# EUROPEAN PATENT SPECIFICATION

(11) **EP 0 434 246 B1**
(45) Date of publication and mention of the grant of the patent: **14.09.1994**
(21) Application number: 90313037.5
(22) Date of filing: 30.11.1990
(51) Int. Cl.: H01L 39/24, H01L 39/14

(54) **Method and apparatus for producing tape superconductors**
Verfahren und Apparat zur Herstellung bandförmiger Supraleiter
Méthode et appareil pour fabriquer des bandes supraconductrices

(30) Priority: 18.12.1989 US 451651
(43) Date of publication of application: 26.06.1991
(73) Proprietor: GENERAL ELECTRIC COMPANY, Schenectady, NY 12345 (US)
(72) Inventor: Savkar, Sudhir Dattatraya, Schenectady, New York 12309 (US); Penney, Carl Murray, Saratoga Springs, New York 12866 (US)
(74) Representative: Pratt, Richard Wilson

(56) References cited:
- DE-A- 2 108 635
- US-A- 4 088 512
- PATENT ABSTRACTS OF JAPAN, vol. 13, no. 523 (C-656), 21st November 1989 ; & JP-A-1212747

## Description

The present invention relates to a method and apparatus for producing superconductors in the form of an elongated tape.

Although there is considerable technical and economic incentive to make superconducting magnets from A-15 type superconductors, especially from the so-called post-Niobium-Tin superconductors, e.g., Nb-Al, Nb-GE, Nb-Ga, this new class of superconductors have proven to be difficult to process into bundles of fine wire as had been the practice with superconducting compounds previously used, such as niobiumtitanium. Further, attempts to date at making tape superconductors of the A-15 type have been successful in producing only short lengths of tape superconductors. Splicing such short lengths into longer, useful lengths of superconductor tape creates serious problems with the reliability of the conductor.

Perhaps the most common processes to date for forming A-15 type superconducting materials are plasma spray forming and the melt spinning. The former has the disadvantage that the conductors must be formed in relatively thick sections in order to ensure continuity of the superconductor material and of its superconductive properties. The melt spinning process has the disadvantage that there is a limitation on the amount of material which can be molten and ejected out under pressure to form a thin film on a substrate. The process is therefore not believed to be well suited for large scale production of superconductor products. Chemical vapor deposition (CVD) could be employed as well, but this process is slow and costly and also would not be well suited for large scale production.

Other processes disclosed in the art include forming a bulk "tape" of the superconducting material and heating and melting a center part of the tape such that the melted and resolidified section forms a compound superconductor region on the tape. The process has at least one disadvantage in that a much larger amount of the base material is required than is actually converted to the superconductive material. A further process disclosed in the art calls for forming a substrate of one of the elements of the compound superconductor and applying to the substrate a coating of a second element of the compound, heat treating the coated substrate to produce intermetallic compounds, and subsequently irradiating the coated substrate with a high-energy density beam such as an electron beam or laser beam. The process has the disadvantage that numerous process steps are required before the superconducting material is produced. Because both of these processes involve preparing a substrate for later processing, the processes will generally only be useful in producing superconductors of some finite length. Still other methods proposed in the art have similar drawbacks and provide further evidence of the difficulties in producing superconductor products using A-15 type compound superconductors.

One aspect of the present invention provides a method involving continuously melting the end of a wire feedstock made of a compound superconductor material, thereby forming a molten bead of the material at the tip of the wire, and passing a cooled tape substrate or backing material into contact with the molten bead to wipe the molten material onto the substrate. The wire feedstock is continuously advanced as the end is melted and wiped onto the substrate, and a film of the molten superconductor compound material is formed and resolidifies on e tape substrate, thus forming a superconductive tape product.

Laser heating of the wire feedstock is preferably employed to produce the molten bead at the end of the wire, although alternative approaches can be employed, such as generating an arc at the tip of a pair of wires in a manner similar to an arc welding process.

A method of the present invention may also be performed as a two step process, wherein a first film of one of the elements of the compound superconductor is laid down on the substrate and the second element is laid down on top of the first film. The thickness and continuity of the deposited films can be monitored and controlled using a laser tracking system. The tape may then optionally be heated to induce a diffusion reaction between the films of the two elements to produce the superconductor, either "on-line" with a subsequent heating device, or "off-line" at a later point in time.

Apparatus according to the present invention includes a means for melting a tip of the wire to produce a molten bead, a means for transporting a tape substrate of extended length in a predetermined direction with respect to the molten bead and into contact with the molten bead to wipe molten material from the bead onto the substrate to form a film of superconductor material, a means for continuously feeding the wire toward the substrate to me melted to replace molten material wiped from the bead, and a means for cooling the film to solidify the superconducting material.

Embodiments of the invention disclosed herein seek to provide:-
a simplified method for producing long lengths of superconductor tape;
a method for producing a superconductive tape of an A-15 type compound superconductor suitable for use in superconductor magnets;
a method for substantially continuous production of superconductive tape products of indeterminate length;
a method for producing superconductor tape products which is especially well suited for on-line dimensional control and quality control of the tape product; and/or
an apparatus for producing elongated tape superconductors at speeds suitable for large scale production.

The invention will be more easily understood from the following detailed description of the preferred embodiments of the present invention taken in conjunction with the accompanying drawings wherein like reference characters represent like parts throughout the several views, and wherein:
FIG. 1 is a side view of an apparatus used in practicing the method of producing a tape superconductor in accordance with a preferred embodiment of the present invention;
FIG. 2 is a side view of an apparatus used in practicing an alternate preferred version of the method of the present invention;
FIG. 3 is a substantially schematic representation of an alternate apparatus which may be used in practicing the method of the present invention;
FIG. 4 is a further substantially schematic representation of an alternate apparatus which may be used in practicing the method of the present invention.

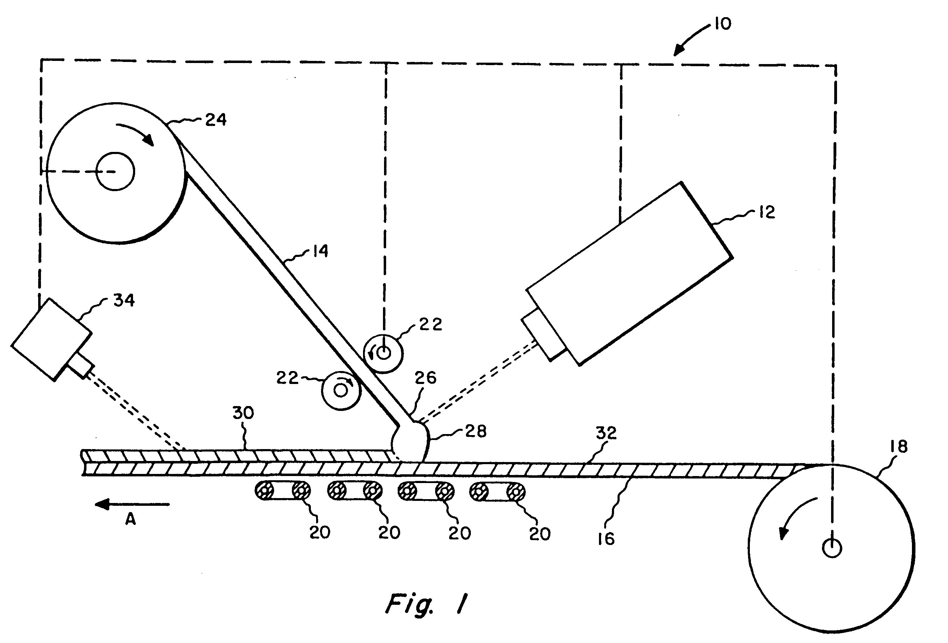

Referring initially to FIG. 1, an apparatus 10 for producing tape superconductors according to the method of the present invention is depicted. A high powered laser heat source 12 of a type known generally in the art is positioned such that the laser beam is directed at the tip of a wire 14 which, in this embodiment, is made up of the superconductor compound material. The apparatus and method of the present invention are particularly well suited for use with A-15 type superconductors, e.g. Nb-Al, Nb-Ge, Nb-Ga and Nb-Sn, although other superconductor materials may be employed in producing tape superconductors.

One potentially significant advantage found in the method of the present invention is that the method may be carried out without the necessity of employing a vacuum chamber or otherwise drawing a vacuum in any part of the process. It is expected that the method will preferably be carried out in a controlled air or inert gas environment, either of which provides relative simplicity of operation as compared to the use of a vacuum chamber which other of the known processes employ.

A cooled substrate or backing material 16, such as copper, is disposed to pass in close proximity to the tip of the superconductor wire 14 when the substrate is moved horizontally and axially in a direction along a longitudinal axis of the apparatus, as indicated by arrow A, past the tip of the wire. The tape substrate may be supplied in any conventional manner, shown in FIG. 1 as being unwound from supply roll 18. The cooling of the substrate may be accomplished in a conventional manner, by passing the substrate through a refrigeration unit or chill rolls ahead of the point where the superconductor wire 14 is located, or may be cooled from underneath by coils 20, as depicted substantially schematically in FIG. 1. Substrate 16 is chilled in order to prevent the possibility that the substrate will melt when the film is deposited thereon, and also to effect a rapid quench and solidification of the film, and therefore the means for chilling the substrate is preferably designed to chill the substrate both immediately before the molten material is deposited, and immediately thereafter.

The superconductor wire 14 is continuously fed in a direction toward substrate 16, passing between roller guides 22 at a location above the substrate and above the tip area of the wire irradiated by the laser beam, in order to support the wire and maintain the position of the wire tip at a substantially constant location. The wire feed system may be of a type used in consumable electrode arc welding processes, indicated substantially schematically by spool 24 from which the wire is fed. Roller guides 22 and/or spool 24 may be driven in order to feed the wire toward the substrate.

In this preferred embodiment of the method of the present invention, the laser heat source 12 directs a laser beam with substantial power at the tip 26 of the superconductor wire 14, which melts the wire material to form a molten bead 28 of the superconducting material. A suitable laser source could be a commercially available CO₂ laser with a power output capability which, depending upon several factors including the speed at which the process is carried out, would be about 50W minimum to about 1000W maximum. The substrate 16 is positioned to be in contact with this molten bead 28, and as the substrate is moved laterally with respect to the bead, molten material is wiped onto the substrate to form a superconductor film 30 on a top surface 32 of the substrate 16. The speed of travel of the substrate and of the wire feed are preferably coordinated such that the wire 14 is continuously fed toward the substrate and melted by the laser heat source to continuously replenish the molten bead, with the bead formed at the tip of the wire being wiped onto the substrate to produce a continuous film of a predetermined thickness. Stated another way, it is preferred in the present apparatus and method to maintain the molten bead at a substantially constant volume as the process takes place. The thickness of the deposited film may preferably range from about 1.27 mm (1/2 mil) to about 5.08 (2 mils), although other thicknesses may prove to be suitable in various applications.

Because the substrate is cooled in this preferred embodiment, the molten superconductor material is quickly quenched and solidified once the material exits the area heated by laser 12. The finished product, comprising the substrate and the superconductive film disposed thereon can be made in long, substantially continuous lengths, the length being theoretically limited only by the length of the tape substrate starter material and/or the upper limit of the length of a wire feedstock which can be continuously supplied by the wire feed system.

The upper surface 32 of the tape substrate 16 may optionally be treated in order to improve the wettability of the substrate which will have the effect of improving the bonding of the superconductive film thereto. Examples of such treatments would be an acid cleaning of the surface or other treatments to remove oxides therefrom, or a physical roughening of the surface.

The method of the present invention lends itself well to on-line control, whether automatic or manual, in obtaining a tape having desired dimensions, especially a thickness dimension, and also having a desired level of deposit continuity and quality. A laser tracking system, shown schematically at 34, similar in pertinent respect to arc bead laser tracking system previously developed for use in arc welding processes, is especially well suited for monitoring and controlling the thickness and deposit continuity (quality) of the superconductor material deposited on the tape. It will be readily recognized that both the wire feed rate and the speed of travel of the substrate could be varied, as well as the melting of the wire, in controlling the thickness of the deposited film. Increasing the speed of travel of the tape substrate would have a tendency to result in a thinner superconductive film layer, as would a reduction in the wire feed rate and in the melting of the wire. Conversely, a decrease in e speed of travel of the tape substrate or an increase in the wire feed rate (assuming that the laser has sufficient power to completely melt the tip of the wire at such a rate) would tend to have the effect of increasing the resulting thickness of the superconductive film.

As indicated previously, a preferred thickness for the deposited material may be selected in a range from about 1.27 to 5.08 mm (1/2 mil to 2 mils). The laser tracking system 34 will thus preferably contain process control hardware and/or software and will preferably be operatively coupled to the various components responsible for the substrate supply rate, the wire feed rate and the power output of the laser heat source, as indicated by broken lines in FIG. 1. Other monitoring and control means previously employed in the art may be used in performing these functions as well.

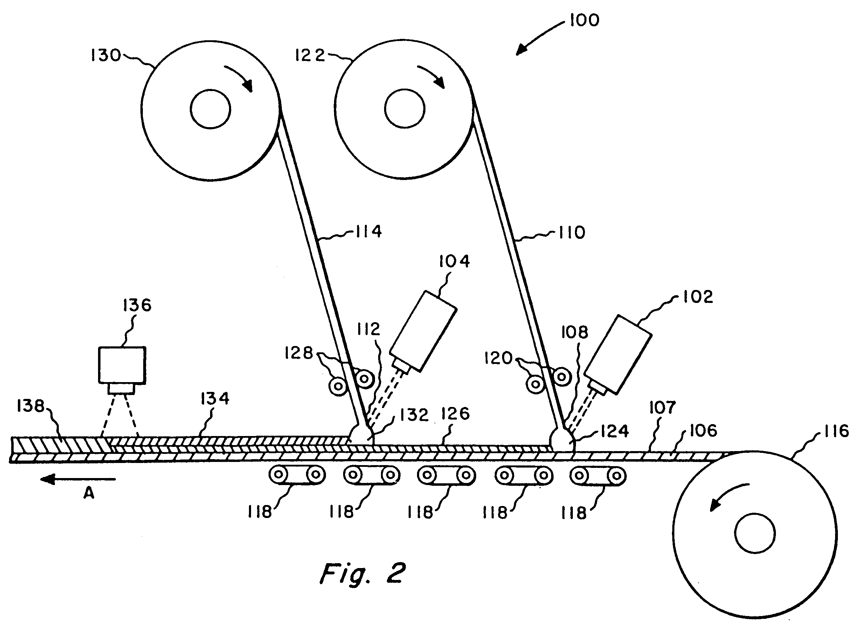

FIG. 2 depicts an apparatus 100 which may be employed to perform the method described above, or, where desired, a variation of that method. Except where indicated to the contrary, the components depicted in FIG. 2 will preferably have the same operating characteristics as the analogous components depicted and described with respect to Claim 1. The apparatus in this embodiment comprises a first and a second laser heat source 102, 104, respectively, of a type known generally in the art. The laser heat sources 102, 104 are spaced apart from one another with respect to an axial direction of travel A of tape substrate 106. The first laser heat source is positioned to direct a laser beam at the tip 108 of a first wire 110 made up of a first element from which the compound superconductor is to be formed.

The second laser heat source 104 is positioned "downstream" of first laser heat source 102, the downstream direction being determined by the direction of travel A of the substrate. The second laser heat source is positioned to direct a laser beam at the tip 112 of a second wire 114 made up of a second element from which the compound superconductor is to be formed.

The tape substrate or backing material 106 is preferably cooled in a manner similar to the FIG. 1 embodiment, and is disposed to pass in close proximity to the tips 108, 112 of the first and second superconductor wires 110, 114, when the substrate is moved horizontally, as indicated by arrow A, past the tips of the wires. As in the FIG. 1 embodiment, substrate 106 may be supplied from a supply roll 116, or other conventional means, and the cooling of the substrate can be accomplished through the use of cooling coils 118.

The first wire 110 is continuously fed in a direction toward substrate 106, passing between roller guides 120 at a location above the substrate and above the tip area of the wire which is to be irradiated by the laser beam. The roller guides are provided in order to support the wire and maintain the position of the wire tip at a substantially constant location. The wire feed system, represented by spool 122, may be of a type used in conventional arc welding processes as discussed above with respect to FIG. 1.

The first laser heat source 102 directs a high energy laser beam at the tip 108 of the first wire 110, which heats and melts the wire material, thus forming first molten bead 124. As in the FIG. 1 apparatus, substrate 106 is positioned to be in contact with the molten bead 124, and as the substrate is moved laterally with respect to me bead, molten material from the bead is continuously wiped from the wire onto substrate 106 to form a first film 126 on the upper surface 107 of the substrate, in a manner substantially identical to the method in FIG. 1.

The second wire 114 is continuously fed toward substrate 106, passing between roller guides 128 at a location above the substrate 106 and first deposited film 126 and above the tip area of the wire which is to be irradiated by the second laser beam. The wire feed system which his preferably identical to that previously described, is represented by spool 130.

The second laser heat source 104 directs a high energy laser beam at the tip of 112 of second wire 114, which heats and melts the wire material, thus forming second molten bead 132. Molten material from the second molten bead is continuously wiped from the wire onto the first film 126, which forms a second film layer 134 disposed on top of first film 126.

The two wires 110, 114, and thus the two film layers 126, 134, in this embodiment preferably comprise the two elements from which the compound superconductor is formed. For example, in producing a niobium-tin compound superconductor, the first wire used to lay down the first film 126 may comprise niobium (Nb), and the second wire, forming second film 134, would comprise tin (Sn). Superconductive properties are attained in such a structure by diffusion of a sufficient quantity of the tin into the niobium such that an Nb₃Sn (A-15 type) phase is formed. In this "two step" process described with respect to FIG. 2, it may be possible to achieve an adequate level of diffusion without further processing, particularly if the second film is deposited in its molten state on a first film which has not been fully quenched.

While it is generally recognized that, in order to obtain adequate levels of diffusion with the materials of interest herein, the materials must be held at a minimum temperature at least one-half of the melting temperature of the material having the higher melting temperature. In the tape superconductor described as an example above, i.e., a niobium-tin superconductor on a copper backing or substrate, the diffusion must take place at a temperature lower than one-half of the melting temperature of niobium (2700°C), as the copper would melt at that temperature. However, a sufficient amount of diffusion may be obtained by slowing the quench rate of the first film 126 deposited on the substrate, and by holding the temperature for a slightly longer time period.

Alternatively, if it is desired to augment the diffusion occurring at the time the second film is deposited, a further reaction between the films may be carried out "on-line" by a further heating device, such as a plasma arc torch 136, of a type known generally in the art. In the example above, the torch 136 may preferably be designed to heat the tape to approximately 900°C, which is roughly 15% cooler than the melting temperature of the copper substrate. The temperature and duration of additional heating can be selected to ensure adequate diffusion of the tin into the niobium, as indicated schematically in FIG. 2 showing a single superconductor film 138 disposed on substrate 106 resulting from the heating and diffusion, even though in reality a complete diffusion of the element is not likely to be actually achieved. The further reaction, where necessary or desirable, may optionally be conducted "off-line", as is done in other processes known in the art.

It is to be recognized that the above method may be practiced with any of the other A-15 type compound superconductors or other compound superconductors in a similar manner. Likewise, the order in which the films are deposited is not believed to be critical to the method, and therefore the secondary element (e.g., Ga, Ge, Al, Sn) may be deposited at the first film, with the niobium being deposited as the second film.

As with the "one-step" process described with respect to FIG. 1, the thickness and continuity of the films deposited on the tape substrate 106 can be monitored and controlled using a laser tracking system operatively coupled with the tape substrate and wire feed speed controls.

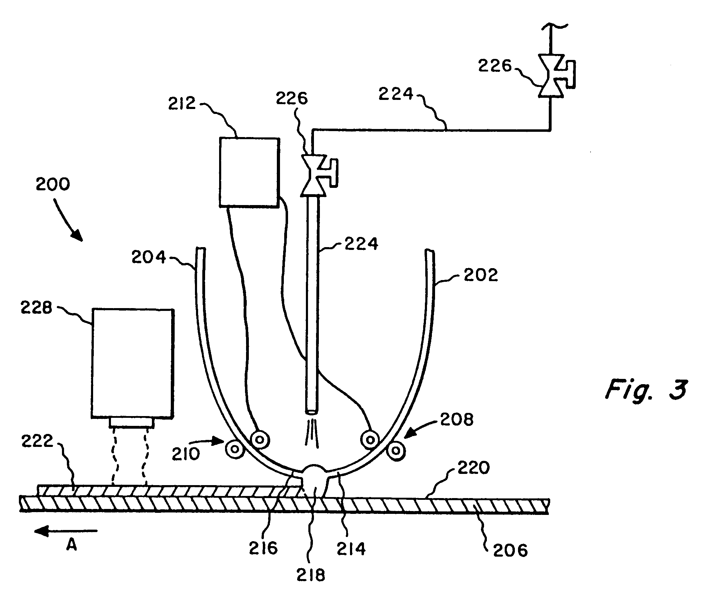

FIG. 3 depicts, in substantially schematic form, an alternative apparatus 200 for producing tape superconductors according to the method of the present invention. This apparatus 200 employs a different means for generating a molten bead of material than those depicted in FIGS. 1 and 2. In this embodiment, an arc is created at the tips of a first and a second superconductor wire 202, 204, respectively, which are fed to a predetermined location immediately above the moving substrate 206.

As in FIGS. 1 and 2, the direction of movement of the substrate is indicated by arrow A, and the substrate 206 may be supplied by any conventional means including a supply roll as depicted in either FIG. 1 or FIG. 2. The first and second wires 202, 204 are likewise continuously supplied in a conventional manner such as a wire spool like those depicted in FIGS. 1 and 2.

In this embodiment, a first and second pair of roller guides 208, 210, associated with the first and second wires 202, 204, act not only to feed and guide the wires to the desired location, but also preferably serve as electrodes to feed current through the wires in a manner similar to conventional DC arc welding process. A conventional DC arc power supply 212 is connected to each of these pairs of roller guides 208, 210, to provide a current running through each of the first and second wires.

The first and second wires 202, 204 are both fed to the same predetermined location, and an arc is struck between the tips 214, 216 of the current-carrying wires, thereby forming a molten bead 218 comprising material melted from the tips of each of the two wires. The moving substrate 206 is positioned, as in FIG. 1 to come into contact with the molten bead 218, and to wipe molten material onto an upper surface 220 of the substrate to form a film 222 which is subsequently quenched to form an elongated superconductive film or tape on tape substrate 206.

The moving substrate 206 is preferably cooled or chilled (cooling means not shown) in a manner similar to the substrates of FIGS. 1 and 2, in order to prevent possible melting of the substrate and to promote a rapid quench of the deposited film. In addition, the FIG. 3 apparatus further includes a means for delivering a cooling gas at the upper side of the molten bead 218 formed in the method described above. The cooling gas may be delivered through schematically depicted conventional tubing 224, in line with one or more valves 226 provided, as necessary, to control the flow rate of the cooling gas or to completely shut off the flow of cooling gas in instances where in is not desired. The flow of cooling gas may improve the process and the quality of the film deposits and tape superconductors produced in that the cooling gas will force the molten bead 218 downwardly toward the substrate, and in addition will assist in quenching the deposited film 222.

The first and second wires 202, 204 are preferably each made of the desired superconductor compound material, whether of the A-15 type or other superconductor compositions. Alternatively, it may be possible to employ as wire feedstock a first wire 202 comprising a first element of the compound superconductor and a second wire 204 comprising the second element of the compound superconductor. For example, a niobium wire and an aluminum wire may be used in the process as first and second wires 202, 204, respectively, and the superconductive compound phase Nb₃Al would have an opportunity form in solution in the molten bead and subsequently be deposited on the substrate 206.

FIG 3 also depicts a plasma arc torch 228 located downstream of the area in which the molten bead is deposited on the substrate to form film 222. The plasma arc torch is employed, as in FIG. 2, to heat the deposited film to promote the diffusion of the elements comprising the compound superconductor. This further heating of the film may not be necessary in all instances as adequate diffusion of the elements may be achieved at the time the film is deposited and before the deposited film 222 has been quenched. Also, it would be possible, if further diffusion of the elements is desired, to carry out an "off-line" diffusion reaction process in lieu of the "on-line" process represented by plasma arc torch 228.

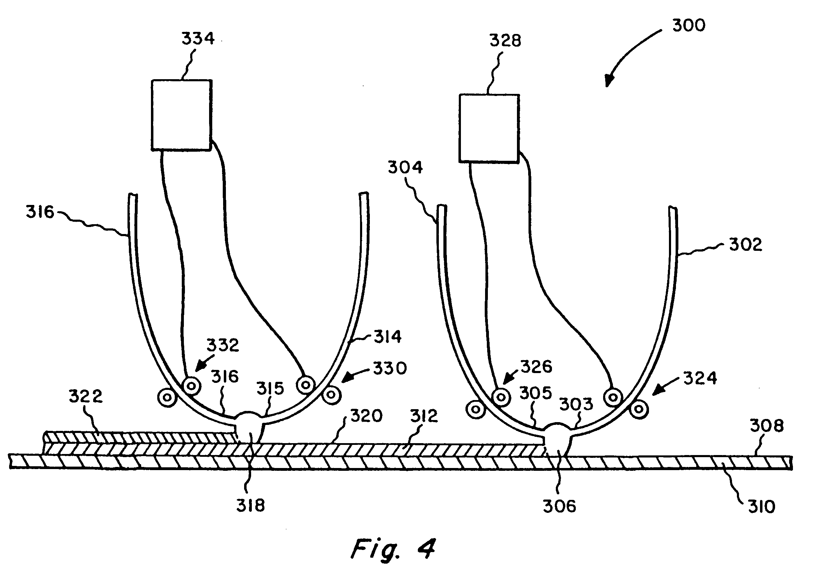

FIG. 4 depicts, in substantially schematic form, a further alternative apparatus 300 for producing tape superconductors according to the method of the present invention. The apparatus in this Figure is used to perform a "two-step" film deposition process similar in many respects to the process described with respect to FIG. 2. For example, the wire feed means and the substrate supply means may preferably be of the same type as those previously described.

In this embodiment, an arc is struck between a first pair of continuously fed first and second wires 302, 304, at the wire tips 303, 305, forming first molten bead 306, which is wiped onto an upper surface 308 of moving tape substrate 310. Downstream of the formation of first film 312, an arc is struck between a second pair of continuously fed first and second wires 314, 316, at the wire tips 315, 317, forming second molten bead 318, which is wiped onto an upper surface 320 of first film 312, thus forming second film 322.

The means for striking the arcs in the FIG. 4 embodiment may preferably be similar to that described with respect to FIG. 3. A first and second pair of roller guides 324, 326 is provided to guide the first pair of first and second wires 302, 304, to the desired predetermined position above substrate 310, and the roller guides 324, 326 are coupled to a first DC arc power supply 328, and serve as electrodes for delivering current through the wire to create the arc. An additional or second pair of first and second roller guides 330, 332 is provided to guide the second pair of first and second wires 314, 316 to the desired predetermined position above first film 312, and the roller guides 330, 332 are coupled to a second DC arc power supply 334, and serve as electrodes for delivering current through the wire to create the arc. Although not shown in FIG. 4, it is to be understood that a cooling gas may preferably be delivered blowing downwardly on each of first and second molten beads 306, 318, in a manner identical to that described with respect to FIG. 3.

In an example in which this embodiment is employed to produce an A-15 type compound superconductor the first pair of first and second wires 302, 304 may comprise niobium or a basic alloy containing niobium, and each of the second pair of first and second wires 314, 316 may preferably comprise the second element (Al, Ga, Ge, Sn) or an alloy of the second element and niobium. The film deposition process itself may, under appropriate circumstances, provide adequate diffusion of the elements in the first and second films in order to produce the compound superconductive material. However, as with the embodiments discussed with respect to FIGs. 1-3, an "on-line" or "off-line" heating of the tape and deposited films to produce further diffusion of the elements may be employed where desired or if required.

## Claims

1. Apparatus for producing a tape superconductor of a compound superconductor type comprising:
means for melting a first wire at a tip thereof to form a first molten bead at said tip;
means for transporting a tape substrate in a predetermined direction relative to said tip of said first wire, said substrate being transported into contact with and axially past said first molten bead formed at said tip of said first wire, wherein molten material from said first molten bead is wiped onto an upper surface of said tape substrate to form a first film thereon;
means for substantially continuously feeding said first wire as said tip of said first wire is progressively melted by said melting means and wiped onto said substrate; and
means for cooling said substrate when said substrate is transported into contact with and past said first molten bead.

2. Apparatus as defined in Claim 1 wherein said first wire is made of a material containing the elements comprising said compound superconductor.

3. Apparatus as defined in Claim 2 wherein said melting means comprises a laser heat source having sufficient power output to melt said first wire.

4. Apparatus as defined in Claim 3 wherein said cooling means further comprises means for rapidly quenching said first film formed on said substrate.

5. Apparatus as defined in Claim 1 wherein said tape substrate transported by said transporting means is of indeterminate length.

6. Apparatus as defined in Claim 3 wherein said first film formed on said substrate has a predetermined desired thickness selected in a range of from 1.27 to 5.08 mm (1/2 mil to 2 mils).

7. Apparatus as defined in Claim 6 further comprising means for monitoring said first film deposited on said substrate and means for controlling a thickness of said film deposited coupled to said monitoring means and coupled tot least one of said melting means, transporting means and wire feeding means.

8. Apparatus as defined in Claim 7 wherein said monitoring means comprises a laser tracking system.

9. Apparatus as defined in Claim 1 wherein said first wire consists essentially of a first element of a two element compound superconductor, and said apparatus further comprises:
means for melting a second wire at a tip thereof to form a second molten bead at said tip, wherein said second wire consists essentially of a second element of said two or more element compound superconductor, and wherein said transporting means is so constructed and arranged to transport said substrate and said first film into contact with and axially past said second molten bead formed at said tip of said second wire, wherein molten material from said second molten bead is wiped onto an upper surface of said first film to form a second film thereon;
means for substantially continuously feeding said second wire as said tip of said second wire is progressively melted by said melting means and wiped onto said first film; and
means for cooling said substrate when said substrate is transported past said second molten bead.

10. Apparatus as defined in Claim 9 further comprising means for heating said first and said second films disposed on said substrate to a temperature and for a time sufficient to induce diffusion of elements between said first and second films as said substrate is transported.

11. Apparatus as defined in Claim 1 wherein said melting means further comprises means for generating an arc between said tip of said first wire and a tip of a second wire, said first and second wires forming a first pair of wires, to form said first molten bead at said tips; and
means for substantially continuously feeding said second wire of said first pair of wires as said first molten bead is progressively wiped onto said tape substrate.

12. Apparatus as defined in Claim 11 wherein said means for generating said arc comprises a DC power supply conductively coupled to said first and second wires of said first pair of wires.

13. Apparatus as defined in Claim 12 further comprising means for generating an arc between a tip of a first and second wires of a second pair of wires to form a second molten bead at said tips, wherein said transporting means is so constructed and arranged to transport said substrate and said first film into contact with and axially past said second molten bead formed at said tips of said second pair of wires, wherein molten material from said second molten bead is wiped onto an upper surface of said first film to form a second film thereon;
means for substantially continuously feeding said first and second wires of said second pair of wires as said second molten bead is progressively wiped onto said first film; and
means for cooling said substrate when said substrate is transported past said second molten bead.

14. Apparatus as defined in Claim 13 wherein said first and second wires of said first pair of wires comprises a first element of a two element compound superconductor and said first and second wires of said second pair of wires comprise a second element of said two element compound superconductor.

15. Apparatus as defined in Claim 12 further comprising means for supplying a cooling gas to an upper side of said first molten bead.

16. Apparatus as defined in Claim 13 further comprising means for supplying a cooling gas to an upper side of said first molten bead and to an upper side of said second molten bead.

17. A method of producing a tape superconductor of a compound superconductor type comprising the steps of:
feeding a wire comprising elements of said superconducting compound in a substantially continuous manner and in a direction toward a tape substrate;
melting a tip of said wire to form a molten bead at said tip;
wiping molten material from said molten bead onto said tape substrate to form a film thereon by transporting said tape substrate axially past a predetermined position wherein said substrate contacts said molten bead, said tape substrate further being transported in a predetermined axial direction relative to said molten bead; and
cooling said film to solidify said film into a superconducting compound.

18. A method of producing a tape superconductor of a compound superconductor type comprising the steps of:
feeding a first wire comprising at least a first elements of said superconductor in a substantially continuous manner and in a direction toward a tape substrate;
melting a tip of said first wire to form a first molten bead at said tip;
wiping molten material from said molten bead onto said tape substrate to form a first film thereon by transporting said tape substrate axially past a predetermined position wherein said substrate contacts said first molten bead, said tape substrate further being transported in a predetermined axial direction relative to said first molten bead;
feeding a second wire comprising at least a second element of said compound superconductor in a substantially continuous manner and in a direction toward said tape substrate and said first film deposited thereon;
melting a tip of said second wire to form a second molten bead at said tip;
wiping molten material from said second molten bead onto said first film previously wiped onto said tape substrate to form a second film thereon by transporting said tape substrate axially past a predetermined position wherein said first film contacts said second molten bead, said tape substrate further being transported in a predetermined axial direction relative to said second molten bead; and cooling said first and second films to solidify said films.

19. A method as defined in Claim 17 wherein said molten bead is formed by laser melting of said tip.

20. A method as defined in Claim 18 wherein said first and said second molten beads is formed by laser melting of said tip of said first and second wires.

21. A method as defined in Claim 19 comprising the further step of
heating said film on said tape substrate to a temperature and for a time sufficient to induce diffusion of the elements in the film.

22. A method as defined in Claim 20 comprising the further step of
heating said first and said second films disposed on said tape substrate to a temperature and for a time sufficient to induce diffusion of the elements between the first and second films.

23. A method as defined in Claim 21 comprising the further step of:
monitoring a thickness and a continuity of said film wiped onto said tape substrate; and
selectively controlling, based on said monitoring of said thickness and said continuity of said film, at least one process parameter in order to maintain said thickness and said continuity within predetermined limits.

24. A method as defined in Claim 22 comprising the further step of:
monitoring a thickness and a continuity of said film wiped onto said tape substrate; and
selectively controlling, based on said monitoring of said thickness and said continuity of said film, at least one process parameter in order to maintain said thickness and said continuity within predetermined limits.

25. A method of producing a tape superconductor of a compound superconductor type comprising the steps of:
forming a first molten bead of the compound Superconductor material from at least one wire at a predetermined position;
wiping molten material from said first molten bead onto a tape substrate to form a first film thereon by transporting said tape substrate axially past said predetermined position and into contact with said first molten bead disposed at said predetermined position;
feeding said at least one wire in a substantially continuous manner to said predetermined position and melting a tip of said at least one wire at substantially the same rate as said molten material is removed from said first molten bead by said tape substrate to maintain said first molten bead at a substantially constant volume; and
cooling said first film to form said compound superconductor.

26. A method as defined in claim 25 comprising the further steps of:
feeding, in a substantially continuous manner, a first pair of wires comprising said at least one wire and a second wire to said predetermined location; and
striking and maintaining an arc between a tip of said at least one wire and a tip of said second wire to melt said tips to form said first molten bead.

27. A method of producing a tape superconductor of a compound superconductor type comprising the steps of:
forming a first molten bead comprising at least a first element of the compound superconductor material from a pair of wires at a first predetermined position position by striking and maintaining an arc between a tip of each of said first pair of wires;
wiping molten material from said first molten bead onto a tape substrate to form a first film thereon by transporting said tape substrate axially past said predetermined position and into contact with said first molten bead disposed at said first predetermined position;
feeding said at least one wire in a substantially continuous manner to said first predetermined position and melting said tips of said first pair of wires at substantially the same rate as molten material is removed from said first molten bead by said tape substrate to maintain said first molten bead at a substantially constant volume;
forming a second molten bead, from a second pair of wires at a second predetermined position by striking and maintaining an arc between a tip of each of said second pair of wires, said second molten bead comprising an element of said compound superconductor material other than said first element;
wiping molten material from said second molten bead onto said first film formed on said tape substrate to form a second film on said tape substrate by transporting said tape substrate axially past said second predetermined position and into contact with said second molten bead;
feeding said second pair of wires in a substantially continuous manner to said second predetermined position and melting said tips of said second pair of wires at substantially the same rate as molten material is removed from said second molten bead by said tape substrate to maintain said second molten bead at a substantially constant volume; and
cooling said first film and said second film to solidify said films.

28. A method as defined in Claim 26 comprising the further step of:
heating said first film on said tape substrate to a temperature and for a time sufficient to induce diffusion within said superconductor material.

29. A method as defined in Claim 27 comprising the further step of:
heating said first film on said second film on said tape substrate to a temperature and for a time sufficient to induce diffusion between said first film and second second film.

30. A method as defined in Claim 26 comprising the further step of:
monitoring a thickness of said first film deposited on said tape substrate using a laser tracking source; and
controlling a thickness of said first film based on information obtained from said monitoring of said first film.

31. A method as defined in Claim 27 comprising the further step of:
monitoring a thickness of each of said first and said second films using a laser tracking source; and
controlling a thickness of each of said first and said second films based on information obtained from said monitoring of said first and said second films.

32. A method as defined in Claim 25 or 27 wherein said tape substrate has an indeterminate length.

33. A method as defined in Claim 32 wherein said tape substrate is made of copper.

34. A method as defined in Claim 25 comprising the further step of providing a downwardly directed cooling gas at an upper side of said first molten bead.

35. A method as defined in Claim 27 comprising the further step of providing a downwardly directed cooling gas at an upper side of each of said first and said second molten bead.

36. A method as defined in Claim 25 or 27 wherein said compound superconductor is of the A-15 type.

## Patentansprüche

1. Vorrichtung zum Herstellen eines bandförmigen Supraleiters aus einer Supraleiter-Verbindung, umfassend:
eine Einrichtung zum Schmelzen eines ersten Drahtes an einer Spitze davon, um einen ersten kugelförmigen Körper an dieser Spitze zu bilden;
eine Einrichtung zum Transportieren eines Bandsubstrates in einer vorbestimmten Richtung mit Bezug auf die Spitze des ersten Drahtes, wobei das Substrat in Kontakt mit und axial vorbei an dem ersten geschmolzenen kugelförmigen Körper, der an der Spitze des ersten Drates gebildet ist, transportiert wird, wodurch geschmolzenes Material von dem ersten geschmolzenen kugelförmigen Körper auf eine obere Oberfläche des Bandsubstrates gewischt wird, um einen esten Film darauf zu bilden;
eine Einrichtung, um im wesentlichen kontinuierlich den ersten Draht zuzuführen, während die Spitze des ersten Drahtes fortschreitend durch die Schmelzeinrichtung geschmolzen und auf das Substrat gewischt wird und eine Einrichtung zum Kühlen des Substrates, wenn das Substrat in Kontakt mit dem und vorbei an dem ersten geschmolzenen kugelförmigen Körper transportiert wird.

2. Vorrichtung nach Anspruch 1, worin der erste Draht aus einem Material hergestellt ist, der die Elemente enthält, die den Verbindungs-Supraleiter umfassen.

3. Vorrichtung nach Anspruch 2, worin die Schmelzeinrichtung eine Laser-Wärmequelle umfaßt, die genügend Energieabgabe aufweist, um den ersten Draht zu schmelzen.

4. Vorrichtung nach Anspruch 3, worin die Kühleinrichtung weiter eine Einrichtung zum raschen Abschrecken des auf dem Substrat gebildeten ersten Filmes umfaßt.

5. Vorrichtung nach Anspruch 1, worin das Bandsubstrat, das durch die Transporteinrichtung transportiert wird, von unbestimmter Länge ist.

6. Vorrichtung nach Anspruch 3, worin der erste auf dem Substrat gebildete Film eine vorbestimmte erwünschte Dicke, ausgewählt aus einem Bereich von 1,27 bis 5,08 mm (1/2 mil bis 2 mils) hat.

7. Vorrichtung nach Anspruch 6, weiter umfassend eine Einrichtung zum Überwachen des auf dem Substrat abgeschiedenen ersten Filmes und eine Einrichtung zum Kontrollieren einer Dicke des abgeschiedenen Filmes, die mit der Überwachungseinrichtung und mindestens einer der Schmelzeinrichtung, Transporteinrichtung und Drahtzufuhreinrichtung gekoppelt ist.

8. Vorrichtung nach Anspruch 7, worin die Überwachungseinrichtung eine Laser-Abtasteinrichtung umfaßt.

9. Vorrichtung nach Anspruch 1, worin der erste Draht im wesentlichen aus einem ersten Element eines Supraleiters aus einer Verbindung aus zwei Elementen besteht und die Vorrichtung weiter umfaßt:
eine Einrichtung zum Schmelzen eines zweiten Drahtes an einer Spitze davon, um einen zweiten geschmolzenen kugelförmigen Körper an dieser Spitze zu bilden, wobei der zweite Draht im wesentlichen aus einem zweiten Element des Supraleiters aus einer Verbindung aus zwei oder mehr Elementen besteht, und worin die Transporteinrichtung so konstruiert und angeordnet ist, das Substrat und den ersten Film in Kontakt mit und axial vorbei an dem zweiten geschmolzenen kugelförmigen Körper zu transportieren, der an der Spitze des zweiten Drahtes gebildet ist, wobei geschmolzenes Material von dem zweiten geschmolzenen kugelförmigen Körper auf eine obere Oberfläche des ersten Filmes gewischt wird, um darauf einen zweiten Film zu bilden;
eine Einrichtung zum im wesentlichen kontinuierlichen Zuführen des zweiten Drahtes, während die Spitze des zweiten Drahtes fortschreitend durch die Schmelzeinrichtung geschmolzen und auf den ersten Film gewischt wird und eine Einrichtung zum Kühlen des Substrates, wenn das Substrat an dem zweiten geschmolzenen kugelförmigen Körper vorbeitransportiert wird.

10. Vorrichtung nach Anspruch 9, weiter umfassend eine Einrichtung zum Erhitzen des ersten und zweiten Films, die auf dem Substrat angeordnet sind, auf eine Temperatur und für eine Dauer, die zum Induzieren von Diffusion von Elementen zwischen dem ersten und zweiten Film genügt, während das Substrat transportiert wird.

11. Vorrichtung nach Anspruch 1, worin die Schmelzeinrichtung weiter eine Einrichtung zum Erzeugen eines Lichtbogens zwischen der Spitze des ersten Drahtes und einer Spitze eines zweiten Drahtes umfaßt, wobei der erste und zweite Draht ein erstes Paar von Drähten bilden, um den ersten geschmolzenen kugelförmigen Körper an den Spitzen zu bilden und
eine Einrichtung zum im wesentlichen kontinuierlichen Zuführen des zweiten Drahtes des ersten Drahtpaares, während der erste geschmolzene kugelförmige Körper fortschreitend auf das Bandsubstrat gewischt wird.

12. Vorrichtung nach Anspruch 11, worin die Einrichtung zum Erzeugen des Lichtbogens eine Gleichstrom-Leistungsquelle umfaßt, die leitend mit dem ersten und zweiten Draht des ersten Drahtpaares gekoppelt ist.

13. Vorrichtung nach Anspruch 12, weiter umfassend eine Einrichtung zum Erzeugen eines Lichtbogens zwischen einer Spitze eines ersten und zweiten Drahtes eines zweiten Drahtpaares zur Bildung eines zweiten geschmolzenen kugelförmigen Körpers an den Spitzen, worin die Transporteinrichtung so konstruiert und angeordnet ist, daß das Substrat und der erste Film in Kontakt mit und axial vorbei an dem zweiten geschmolzenen kugelförmigen Körper transportiert wird, der an den Spitzen des zweiten Drahtpaares gebildet ist, wobei geschmolzenes Material vom zweiten geschmolzenen kugelförmigen Körper auf eine obere Oberfläche des ersten Filmes gewischt wird, um einen zweiten Film darauf zu bilden;
eine Einrichtung zum im wesentlichen kontinuierlichen Zuführen des ersten und zweiten Drahtes des zweiten Drahtpaares, während der zweite geschmolzene kugelförmige Körper fortschreitend auf den ersten Film gewischt wird und eine Einrichtung zum Kühlen des Substrates, wenn das Substrat an dem zweiten geschmolzenen kugelförmigen Körper vorbeitransportiert wird.

14. Vorrichtung nach Anspruch 13, worin der erste und zweite Draht des ersten Drahtpaares ein erstes Element eines Supraleiters aus einer Verbindung aus zwei Elementen umfaßt und der erste und zweite Draht des zweiten Drahtpaares ein zweites Element des Supraleiters aus einer Verbindung aus zwei Elementen umfaßt.

15. Vorrichtung nach Anspruch 12, weiter umfassend eine Einrichtung zum Zuführen eines Kühlgases zu einer oberen Seite des ersten geschmolzenen kugelförmigen Körpers.

16. Vorrichtung nach Anspruch 13, weiter umfassend eine Einrichtung zum Zuführen eines Kühlgases zu einer Oberseite des ersten geschmolzenen kugelförmigen Körpers und zu einer Oberseite des zweiten geschmolzenen kugelförmigen Körpers.

17. Verfahren zum Herstellen eines bandförmigen Supraleiters aus einem Supraleiter aus einer Verbindung, umfassend die Stufen:
Zuführen eines Drahtes, umfassend Elemente der supraleitenden Verbindung in einer im wesentlichen kontinuierlichen Weise und in einer Richtung zu einem Bandsubstrat; Schmelzen einer Spitze des Drahtes, um einen geschmolzenen kugelförmigen Körper an der Spitze zu bilden;
Wischen geschmolzenen Materials von dem geschmolzenen kugelförmigen Körper auf das Bandsubstrat, um einen Film darauf zu bilden, indem das Bandsubstrat axial an einer vorbestimmten Position vorbeitransportiert wird, in der das Substrat den geschmolzenen kugelförmigen Körper berührt, wobei das Bandsubstrat weiter in einer vorbestimmten axialen Richtung mit Bezug auf den geschmolzenen kugelförmigen Körper transportiert wird und
Kühlen des Filmes, um den Film zu einer supraleitenden Verbindung zu verfestigen.

18. Verfahren zum Herstellen eines bandförmigen Supraleiters aus einem Supraleiter aus einer Verbindung, umfassend die Stufen:
Zuführen eines ersten Drahtes, umfassend mindestens ein erstes Element des Supraleiters in einer im wesentlichen kontinuierlichen Weise und in einer Richtung auf ein Bandsubstrat zu;
Schmelzen einer Spitze des ersten Drahtes, um einen ersten geschmolzenen kugelförmigen Körper an der Spitze zu bilden;
Wischen geschmolzenen Materials von dem geschmolzenen kugelförmigen Körper auf das Bandsubstrat, um einen ersten Film darauf zu bilden, durch Transportieren des Bandsubstrates axial an einer vorbestimmten Position vorbei, bei der das Substrat den ersten geschmolzenen kugelförmigen Körper berührt, wobei das Bandsubstrat weiter in einer vorbestimmten axialen Richtung relativ zum ersten geschmolzenen kugelförmigen Körper transportiert wird;
Zuführen eines zweiten Drahtes, umfassend mindestens ein zweites Element des Verbindungs-Supraleiters in einer im wesentlichen kontinuierlichen Weise und in eine Richtung auf das Bandsubstrat und den ersten darauf abgeschiedenen Film zu;
Schmelzen einer Spitze des zweiten Drahtes, um einen zweiten geschmolzenen kugelförmigen Körper an der Spitze zu bilden;
Wischen geschmolzenen Materials von dem zweiten geschmolzenen kugelförmigen Körper auf den ersten Film, der vorher auf das Bandsubstrat gewischt worden war, um einen zweiten Film darauf zu bilden, indem man das Bandsubstrat axial an einer vorbestimmten Position vorbeitransportiert, in der der erste Film den zweiten geschmolzenen kugelförmigen Körper berührt, wobei das Bandsubstrat weiter in einer vorbestimmten axialen Richtung relativ zum zweiten geschmolzenen kugelförmigen Körper transportiert wird und
Kühlen des ersten und zweiten Films, um die Filme erstarren zu lassen.

19. Verfahren nach Anspruch 17, worin der geschmolzene kugelförmige Körper durch Laser-Schmelzen der Spitze gebildet wird.

20. Verfahren nach Anspruch 18, worin der erste und zweite geschmolzene kugelförmige Körper durch Laser-Schmelzen der Spitze des ersten und zweiten Drahtes gebildet wird.

21. Verfahren nach Anspruch 19, umfassend die weitere Stufe des Erhitzens des Films auf dem Bandsubstrat auf eine Temperatur und für eine Zeit, die genügen, um die Diffusion der Elemente in dem Film zu induzieren.

22. Verfahren nach Anspruch 20, umfassend die weitere Stufe des Erhitzens des ersten und zweiten Films, die auf dem Bandsubstrat angeordnet sind, auf eine Temperatur und für eine Zeit, die genügen, um die Diffusion der Elemente zwischen dem ersten und zweiten Film zu induzieren.

23. Verfahren nach Anspruch 21, umfassend die weitere Stufe des Überwachens einer Dicke und einer Kontinuität des auf das Bandsubstrat gewischten Filmes und selektives Kontrollieren, auf der Grundlage der Überwachung der Dicke und der Kontinuität des Films, von mindestens einem Verfahrensparameter, um die Dicke und Kontinuität innerhalb vorbestimmter Grenzen zu halten.

24. Verfahren nach Anspruch 22, umfassend die weitere Stufe des Überwachens einer Dicke und Kontinuität des auf das Bandsubstrat gewischten Filmes und selektives Kontrollieren, auf der Grundlage der Überwachung der Dicke und Kontinuität des Filmes, mindestens eines Verfahrensparameters, um die Dicke und Kontinuität innerhalb vorbestimmter Grenzen zu halten.

25. Verfahren zum Herstellen eines bandförmigen Supraleiters aus einem Supraleiter aus einer Verbindung, umfassend die Stufen:
Bilden eines ersten geschmolzenen kugelförmigen Körpers des supraleitenden Verbindungsmaterials von mindestens einem Draht an einer vorbestimmten Position;
Wischen geschmolzenen Materials von dem ersten geschmolzenen kugelförmigen Körper auf ein Bandsubstrat, um einen ersten Film darauf zu bilden, durch Transportieren des Bandsubstrates axial an der vorbestimmten Position vorbei und in Berührung mit dem ersten geschmolzenen kugelförmigen Körper, der an der vorbestimmten Position angeordnet ist;
Zuführen des mindestens einen Drahtes in einer im wesentlichen kontinuierlichen Weise zu der vorbestimmten Position und Schmelzen einer Spitze mindestens eines Drahtes mit im weasentlichen der gleichen Geschwindigkeit, in der geschmolzenes Material von dem ersten geschmolzenen kugelförmigen Körper durch das Bandsubstrat entfernt wird, um den ersten geschmolzenen kugelförmigen Körper bei einem im wesentlichen konstanten Volumen zu halten und Kühlen des ersten Filmes zur Bildung des Verbindungs-Supraleiters.

26. Verfahren nach Anspruch 25, umfassend die weiteren Stufen:
Zuführen in einer im wesentlichen kontinuierlichen Weise eines ersten Paares von Drähten, umfassend den mindestens einen Draht und einen zweiten Draht zu der vorbestimmten Stelle und
Zünden und Aufrechterhalten eines Lichtbogens zwischen einer Spitze des mindestns einen Drahtes und einer Spitze des zweiten Drahtes, um die Spitzen zu schmelzen und den ersten geschmolzenen kugelförmigen Körper zu bilden.

27. Verfahren zum Herstellen eines bandförmigen Supraleiters aus einem Supraleiter aus einer Verbindung, umfassend die Stufen:
Bilden eines ersten geschmolzenen kugelförmigen Körpers, umfassend mindestens ein Element des supraleitenden Verbindungsmaterials von einem Paar von Drähten in einer ersten vorbestimmten Position durch Zünden und Aufrechterhalten eines Lichtbogens zwischen einer Spitze jedes Drahtes des ersten Drahtpaares;
Wischen geschmolzenen Materials von dem ersten geschmolzenen kugelförmigen Körper auf ein Bandsubstrat zur Bildung eines ersten Filmes darauf durch Transportieren des Bandsubstrates axial an der vorbestimmten Position vorbei und in Kontakt mit dem ersten geschmolzenen kugelförmigen Körper, der sich in der ersten vorbestimmten Position befindet;
Zuführen des mindestens einen Drahtes in einer im wesentlichen kontinuierlichen Weise zu der ersten vorbestimmten Position und Schmelzen der Spitzen des ersten Drahtpaares mit im wesentlichen der gleichen Geschwindigkeit, in der geschmolzenes Material von dem ersten geschmolzenen kugelförmigen Körper durch das Bandsubstrat entfernt wird, um den ersten geschmolzenen kugelförmigen Körper bei einem im wesentlichen konstanten Volumen zu halten;
Bilden eines zweiten geschmolzenen kugelförmigen Körpers von einem zweiten Drahtpaar an einer zweiten vorbestimmten Position durch Zünden und Aufrechterhalten eines Lichtbogens zwischen einer Spitze jedes des zweiten Paares von Drähten, wobei der zweite geschmolzene kugelförmige Körper ein Element des supraleitenden Verbindungsmaterials umfaßt, das ein anderes ist als das erste Element;
Wischen geschmolzenen Materials von dem zweiten geschmolzenen kugelförmigen Körper auf den ersten Film, der auf dem Bandsubstrat ausgebildet ist, zur Bildung eines zweiten Filmes auf dem Bandsubstrat durch Transportieren des Bandsubstrates axial an der zweiten vorbestimmten Position vorbei und in Kontakt mit dem zweiten geschmolzenen kugelförmigen Körper;
Zuführen des zweiten Drahtpaares in einer im wesentlich kontinuierlichen Weise zu der zweiten vorbestimmten Position und Schmelzen der Spitzen des zweiten Drahtpaares mit im wesentlichen der gleichen Geschwindigkeit, in der geschmolzenes Material von dem zweiten geschmolzenen kugelförmigen Körper durch das Bandsubstrat entfernt wird, um den zweiten geschmolzenen kugelförmigen Körper bei einem im wesentlichen konstanten Volumen zu halten und Kühlen des ersten und zweiten Filmes, um die Filme erstarren zu lassen.

28. Verfahren nach Anspruch 26, umfassend die weitere Stufe des Erhitzens des ersten Filmes auf dem Bandsubstrat auf eine Temperatur und für eine Zeit, die genügen, um Diffusion innerhalb des supraleitenden Materials zu induzieren.

29. Verfahren nach Anspruch 27, umfassend die weitere Stufe des Erhitzens des ersten Filmes und des zweiten Filmes auf dem Bandsubstrat auf eine Temperatur und für eine Zeit, die zum Induzieren der Diffusion zwischen dem ersten und dem zweiten Film genügen.

30. Verfahren nach Anspruch 26, umfassend die weitere Stufe des Überwachens einer Dicke des ersten Filmes, der auf dem Bandsubstrat abgeschieden ist, unter Anwendung einer Laser-Abtastquelle und
Kontrollieren einer Dicke des ersten Filmes auf der Grundlage der Information, die aufgrund des Überwachens des ersten Filmes erhalten wurde.

31. Verfahren nach Anspruch 27, umfassend die weitere Stufe des Überwachens einer Dicke jedes des ersten und zweiten Filmes unter Anwendung einer Laser-Abtastquelle und
Kontrollieren einer Dicke jedes des ersten und zweiten Filmes auf der Grundlage der Information, die aus der Überwachung des ersten und zweiten Filmes erhalten wurde.

32. Verfahren nach Anspruch 25 oder 27, worin das Bandsubstrat eine unbestimmte Länge hat.

33. Verfahren nach Anspruch 32, worin das Bandsubstrat aus Kupfer hergestellt ist.

34. Verfahren nach Anspruch 25, umfassend die weitere Stufe der Schaffung eines nach unten gerichteten Kühlgases an einer Oberseite des ersten geschmolzenen kugelförmigen Körpers.

35. Verfahren nach Anspruch 27, umfassend die weitere Stufe der Schaffung eines nach unten gerichteten Kühlgases an einer Oberseite jedes des ersten und zweiten geschmolzenen kugelförmigen Körpers.

36. Verfahren nach Anspruch 25 oder 27, worin die Verbindung des Supraleiters vom A-25-Typ ist.

## Revendications

1. Appareil pour produire un supraconducteur sous forme de bande du type supraconducteur composé, comprenant:
- un moyen pour faire fondre un premier fil métallique à son extrémité pour former une première perle fondue à ladite extrémité;
- un moyen pour transporter un substrat en forme de bande dans une direction prédéterminée par rapport à ladite extrémité dudit premier fil, ledit substrat étant transporté de manière qu'il vienne en contact avec ladite première perle fondue et axialement au-delà de ladite première perle fondue formée à ladite extrémité dudit premier fil, la matière fondue provenant de ladite première perle fondue étant raclée jusque sur la surface supérieure dudit substrat en forme de bande pour y former un premier film;
- un moyen pour avancer de façon substantiellement continue ledit premier fil à mesure que ladite extrémité dudit premier fil est fondue progressivement par ledit moyen de fusion et est raclée jusque sur ledit substrat; et
- un moyen pour refroidir ledit substrat lorsque ce substrat est transporté de manière qu'il vienne en contact avec ladite première perle fondue et au-delà de cette première perle.

2. Appareil selon la revendication 1, dans lequel ledit premier fil est formé d'un matériau contenant les éléments constituant ledit film supraconducteur composé.

3. Appareil selon la revendication 2, dans lequel ledit moyen de fusion comprend une source de chauffage à laser ayant une puissance de sortie suffisante pour faire fondre ledit premier fil.

4. Appareil selon la revendication 3, dans lequel ledit moyen de refroidissement comprend, en outre, un moyen pour refroidir rapidement ledit premier film formé sur ledit substrat.

5. Appareil selon la revendication 1, dans lequel ledit substrat en forme de bande transporté par ledit moyen de transport a une longueur indéterminée.

6. Appareil selon la revendication 3, dans lequel ledit premier film formé sur ledit substrat a une épaisseur désirée prédéterminée sélectionnée dans une plage allant de 1,27 à 5,08 mm (1/2 mil à 2 mils).

7. Appareil selon la revendication 6, comprenant, en outre, un moyen pour contrôler ledit premier film déposée sur ledit substrat et un moyen pour régler l'épaisseur dudit film déposé, ce moyen étant couplé audit moyen de contrôle et étant couplé à au moins l'un des moyens parmi ledit moyen de fusion, ledit moyen de transport et ledit moyen d'avance de fil.

8. Appareil selon la revendication 7, dans lequel ledit moyen de contrôle comprend un système de guidage à laser.

9. Appareil selon la revendication 1, dans lequel ledit premier fil consiste essentiellement en un premier élément d'un supraconducteur à deux composants, et ledit appareil comprend, en outre:
- un moyen pour faire fondre un second fil à son extrémité pour former une seconde perle fondue à ladite extrémité, ledit second fil consistant essentiellement en un second élément dudit supraconducteur à deux ou plus de deux composants, et ledit moyen de transport étant réalisé et agencé de façon à transporter ledit substrat et ledit premier film de manière à les faire venir en contact avec ladite seconde perle fondue et axialement au-delà de cette seconde perle fondue formée à ladite extrémité dudit second fil, le matériau fondu provenant de ladite seconde perle étant raclé jusque sur une surface supérieure dudit premier film pour y former un second film;
- un moyen pour avancer de façon sensiblement continue ledit second fil à mesure que ladite extrémité dudit second fil est fondue progressivement par ledit moyen de fusion et est raclée jusque sur ledit premier film; et
- un moyen pour refroidir ledit substrat lorsque ce substrat est transporté au-delà de ladite seconde perle fondue.

10. Appareil selon la revendication 9, comprenant en outre un moyen pour chauffer lesdits premier et second films disposés sur ledit substrat jusqu'à une température et pendant un temps suffisant pour induire une diffusion des éléments entre lesdits premier et second films à mesure que ledit substrat est transporté.

11. Appareil selon la revendication 1, dans lequel ledit moyen de fusion comprend, en outre:
- un moyen pour engendrer un arc entre ladite extrémité du premier fil et l'extrémité d'un second fil, lesdits premier et second fils formant une première paire de fils, de manière à former ladite première perle fondue auxdites extrémités; et
- un moyen pour avancer de façon sensiblement continue ledit second fil et ladite première paire de fils à mesure que ladite première perle fondue est raclée progressivement jusque sur ledit substrat en forme de bande.

12. Appareil selon la revendication 11, dans lequel ledit moyen pour engendrer ledit arc comprend une source de courant continu couplée de façon conductrice auxdits premier et second fils de ladite première paire de fils.

13. Appareil selon la revendication 12, comprenant en outre un moyen pour engendrer un arc entre une extrémité d'un premier et d'un second fils d'une seconde paire de fils pour former une seconde perle fondue auxdites extrémités, ledit moyen de transport étant réalisé et agencé de façon à transporter ledit substrat et ledit premier film de manière qu'il vienne en contact avec ladite seconde perle fondue et axialement au-delà de cette seconde perle fondue formée auxdites extrémités de ladite seconde paire de fils, le matériau fondu provenant de ladite seconde perle fondue étant raclé jusque sur la surface supérieure dudit premier film pour y former un second film;
- un moyen pour avancer de façon sensiblement continue lesdits premier et second fils de ladite seconde paire de fils à mesure que ladite seconde perle fondue est raclée progressivement jusque sur ledit premier film; et
- un moyen pour refroidir ledit substrat lorsque ce substrat est transporté au-delà de ladite seconde perle fondue.

14. Appareil selon la revendication 13, dans lequel lesdits premier et second fils de ladite première paire de fils comprennent un premier élément d'un supraconducteur à deux composants et lesdits premier et second fils de ladite seconde paire de fils comprennent un second élément dudit supraconducteur à deux composants.

15. Appareil selon la revendication 12, comprenant en outre un moyen pour amener un gaz de refroidissement jusqu'au côté supérieur de ladite première perle fondue.

16. Appareil selon la revendication 13, comprenant en outre un moyen pour amener un gaz de refroidissement jusqu'au côté supérieur de ladite première perle fondue et jusqu'au côté supérieur de ladite seconde perle fondue.

17. Procédé pour produire un supraconducteur sous forme du bande du type supraconducteur composé, comprenant les étapes consistant:
- à avancer un fil comprenant les éléments dudit composé supraconducteur d'une manière sensiblement continue et en direction d'un substrat en forme de bande;
- à faire fondre l'extrémité dudit fil pour former une perle fondue à ladite extrémité;
- à racler le matériau fondu provenant de ladite perle fondue jusque sur ledit substrat en forme de bande pour y former un film en transportant ledit substrat en forme de bande axialement au-delà d'une position prédéterminée où ledit substrat vient en contact avec ladite perle fondue, ledit substrat en forme de bande étant en outre transporté dans une direction axiale prédéterminée par rapport à ladite perle fondue; et
- à refroidir ledit film pour solidifier ce film en formant un composé supraconducteur.

18. Un procédé pour produire un supraconducteur sous forme de bande du type supraconducteur composé, comprenant les étapes consistant:
- à avancer un premier fil comprenant au moins un premier élément dudit supraconducteur d'une manière sensiblement continue en direction d'un substrat en forme de bande;
- à faire fondre l'extrémité dudit premier fil pour former une première perle fondue à ladite extrémité;
- à racler le matériau fondu provenant de ladite perle fondue jusque sur ledit substrat en forme de bande pour y former un premier film en transportant ledit substrat en forme de bande axialement au-delà d'une position prédéterminée où ledit substrat est en contact avec ladite première perle fondue, ledit substrat en forme de bande étant en outre transporté dans une direction axiale prédéterminée par rapport à ladite première perle fondue;
- à avancer un second fil comprenant au moins un second élément dudit supraconducteur composé, d'une manière sensiblement continue et en direction dudit substrat en forme de bande et dudit premier film qui y est déposé;
- à faire fondre l'extrémité dudit second fil pour former une seconde perle fondue à ladite extrémité;
- à racler le matériau fondu depuis ladite seconde perle fondue jusque sur ledit premier film raclé antérieurement jusque sur ledit substrat en forme de bande pour y former un second film en transportant ledit substrat en forme de bande axialement au-delà d'une position prédéterminée où ledit premier film vient en contact avec ladite seconde perle fondue, ledit substrat en forme de bande étant en outre transporté dans une direction axiale prédéterminée par rapport à ladite seconde perle fondue; et
- à refroidir lesdits premier et second films pour solidifier ces films.

19. Procédé selon la revendication 17, dans lequel on forme ladite perle fondue en faisant fondre au laser ladite extrémité.

20. Procédé selon la revendication 18, dans lequel on forme lesdites première et seconde perles fondues en faisant fondre au laser ladite extrémité desdits premier et second fils.

21. Procédé selon la revendication 19, comprenant l'étape supplémentaire consistant:
- à chauffer ledit film sur ledit substrat en forme de bande jusqu'à une température et pendant un temps suffisants pour induire une diffusion des éléments dans le film.

22. Procédé selon la revendication 20, comprenant l'étape supplémentaire consistant à:
- chauffer lesdits premier et second films disposés sur ledit substrat en forme de bande jusqu'à une température et pendant un temps suffisants pour induire une diffusion des éléments entre les premier et second films.

23. Procédé selon la revendication 21, comprenant l'étape supplémentaire consistant:
- à contrôler l'épaisseur et la continuité dudit film raclé jusque sur ledit substrat en forme de bande; et
- à commander sélectivement, en se basant sur ledit contrôle de ladite épaisseur et de ladite continuité du film, au moins un paramètre de processus pour maintenir ladite épaisseur et ladite continuité dans des limites prédéterminées.

24. Procédé selon la revendication 22, comprenant l'étape supplémentaire consistant:
- à contrôler l'épaisseur et la continuité dudit film raclé jusque sur ledit substrat en forme de bande; et
- à régler sélectivement, en se basant sur ledit contrôle de ladite épaisseur et de ladite continuité du film, au moins un paramètre de processus pour maintenir ladite épaisseur et ladite continuité dans des limites prédéterminées.

25. Procédé pour produire un supraconducteur sous forme de bande du type supraconducteur composé, comprenant les étapes consistant:
- à former une première perle fondue du matériau supraconducteur composé à partir d'au moins un fil métallique à une position prédéterminée;
- à racler le matériau fondu depuis ladite première perle fondue jusque sur un substrat en forme de bande pour y former un premier film en transportant ledit substrat en forme de bande axialement au-delà de ladite position prédéterminée et de manière qu'il vienne en contact avec ladite première perle fondue disposée à ladite position prédéterminée;
- à avancer le ou lesdits fil(s) d'une manière sensiblement continue jusqu'à ladite position prédéterminée et à faire fondre l'extrémité du ou desdits fil(s) à une vitesse sensiblement identique à celle à laquelle ledit matériau fondu est enlevé de ladite première perle fondue par ledit substrat en forme de bande pour maintenir ladite première perle fondue à un volume sensiblement constant; et
- à refroidir ledit premier film pour former ledit supraconducteur composé.

26. Un procédé selon la revendication 25, comprenant les étapes supplémentaires consistant:
- à avancer, d'une manière sensiblement continue, une première paire de fils comprenant le ou lesdits fils et un second fil jusqu'à ladite position prédéterminée;
- à faire jaillir et à maintenir un arc entre l'extrémité du ou desdits fils de l'extrémité dudit second fil pour faire fondre lesdites extrémités de manière à former ladite première perle fondue.

27. Procédé pour produire un supraconducteur en forme de bande du type supraconducteur composé, comprenant les étapes consistant:
- à former une première perle fondue comprenant au moins un premier élément du matériau supraconducteur composé à partir d'une paire de fils métalliques à une première position prédéterminée en faisant jaillir et en maintenant un arc entre une extrémité de chaque fil de ladite première paire de fils;
- à racler le matériau fondu depuis ladite première perle fondue jusque sur un substrat en forme de bande pour y former un premier film en transportant ledit substrat en forme de bande axialement au-delà de ladite position prédéterminée et jusqu'à ce qu'il vienne en contact avec ladite première perle fondue disposée à ladite première position prédéterminée;
- à avancer le ou lesdits fils d'une manière sensiblement continue jusqu'à ladite première position prédéterminée et à faire fondre lesdites extrémités de fils de ladite première paire de fils sensiblement à la même vitesse que celle à laquelle le matériau fondu est enlevé de ladite première perle fondue par ledit substrat en forme de bande pour maintenir ladite première perle fondue à un volume sensiblement constant;
- à former une seconde perle fondue, à partir d'une seconde paire de fils, à une seconde position prédéterminée en faisant jaillir et en maintenant un arc entre une extrémité de chaque fil de ladite seconde paire de fils, ladite seconde perle fondue comprenant un élément dudit matériau supraconducteur composé autre que ledit premier élément;
- à racler le matériau fondu depuis ladite seconde perle jusque sur ledit premier film formé sur ledit substrat en forme de bande pour former un second film sur ledit substrat en forme de bande en transportant ledit substrat en forme de bande axialement au-delà de ladite seconde position prédéterminée et de manière qu'il vienne en contact avec ladite seconde perle fondue;
- à avancer ladite seconde paire de fils d'une manière sensiblement continue jusqu'à ladite seconde position prédéterminée et à faire fondre lesdites extrémités de ladite seconde paire de fils sensiblement à la même vitesse que celle à laquelle le matériau fondu est enlevé de ladite seconde perle fondue par ledit substrat en forme de bande pour maintenir ladite seconde perle fondue à un volume sensiblement constant; et
- à refroidir ledit premier film et ledit second film pour solidifier ces films.

28. Procédé selon la revendication 26, comprenant l'étape supplémentaire consistant:
- à chauffer ledit premier film sur ledit substrat en forme de bande jusqu'à une température et pendant un temps suffisants pour induire une diffusion à l'intérieur dudit matériau supraconducteur.

29. Procédé selon la revendication 27, comprenant l'étape supplémentaire consistant:
- à chauffer ledit premier film sur ledit second film se trouvant sur ledit substrat en forme de bande jusqu'à une température et pendant un temps suffisants pour induire une diffusion entre ledit premier film et ledit second film.

30. Procédé selon la revendication 26, comprenant l'étape supplémentaire consistant:
- à contrôler l'épaisseur dudit premier film déposé sur ledit substrat en forme de bande en utilisant une source de guidage à laser; et
- à régler l'épaisseur de chacun desdits premier et second films en se basant sur les informations obtenues à partir dudit contrôle dudit premier film.

31. Procédé selon la revendication 27, comprenant l'étape supplémentaire consistant:
- à contrôler l'épaisseur de chacun desdits premier et second films en utilisant une source de suivi à laser; et
- à régler l'épaisseur de chacun desdits premier et second films en se basant sur les informations obtenues à partir dudit contrôle desdits premier et second films.

32. Procédé selon la revendication 25 ou 27, dans lequel ledit substrat en forme de bande a une longueur indéterminée.

33. Procédé selon la revendication 32, dans lequel ledit substrat en forme de bande est formé de cuivre.

34. Procédé selon la revendication 25, comprenant l'étape supplémentaire consistant à fournir un gaz de refroidissement dirigé vers le bas au niveau du côté supérieur de ladite première perle fondue.

35. Procédé selon la revendication 27, comprenant l'étape supplémentaire consistant à fournir un gaz de refroidissement dirigé vers le bas au niveau du côté supérieur de chacune desdites première et seconde perles fondues.

36. Procédé selon la revendication 25 ou 27, dans lequel ledit supraconducteur composé est du type A-15.
